(19) Europäisches Patentamt

European Patent Office

Office européen des brevets

(11) Veröffentlichungsnummer: **0 397 912 B1**

(12) **EUROPÄISCHE PATENTSCHRIFT**

(45) Veröffentlichungstag der Patentschrift: **10.08.94**

(51) Int. Cl.⁵: **H03H 21/00**

(21) Anmeldenummer: **89109086.2**

(22) Anmeldetag: **19.05.89**

(54) Verfahren und Netzwerkanordnung zur Gewinnung des Gradienten der Ausgangssignale eines gegebenen Netzwerkes zur Verarbeitung zeitdiskreter Signale bezüglich der Netzwerkparameter.

(43) Veröffentlichungstag der Anmeldung:
**22.11.90 Patentblatt  90/47**

(45) Bekanntmachung des Hinweises auf die Patenterteilung:
**10.08.94 Patentblatt  94/32**

(84) Benannte Vertragsstaaten:
**DE FR GB IT NL**

(56) Entgegenhaltungen:

**ICASSP 88; 11th-14th April 1988; New York; J.J. SHYNK: "On lattice-from algorithms for adaptive filtering", pages 1554-1557**

**IEEE TRANSACTIONS ON ACOUSTICS, SPEECH AND SIGNAL PROCESSING vol. ASSP-30, no. 2; April 1982; New York; I.L. AYALA: "On a new adaptive lattice algorithm for recursive filters", pages 316-319**

**IEEE TRANS ASSP-28, no. 1; February 1980; New York, US; D. PARIKH et al.: "An adaptive lattice algorithm for recursive filters", pages 110-111**

(73) Patentinhaber: **SIEMENS AKTIENGESELLSCHAFT**
**Wittelsbacherplatz 2**
**D-80333 München (DE)**

(72) Erfinder: **Kummert, Anton, Dr.-Ing.**
**Wittenerstrasse 25a**
**D-4320 Hattingen 13 (DE)**

## Beschreibung

Die Erfindung betrifft ein Verfahren zur Gewinnung des Gradienten der Ausgangssignale eines gegebenen Netzwerkes zur Verarbeitung zeitdiskreter Signale bezüglich der Netzwerkparameter nach dem Oberbegriff des Patentanspruches 1 und eine Anordnung zur Durchführung des Verfahrens.

Adaptive Netzwerke, wie etwa adaptive Digitalfilter, sind in vielen Bereichen der zeitdiskreten Signalverarbeitung, insbesondere in den Bereichen Systemanalyse, Echokompensation bei Zweidraht-Vierdrahtübergängen, Leitungsentzerrung und Sprachverarbeitung, von großer Bedeutung. Das Charakteristikum solcher adaptiver Netzwerke, im Vergleich zu konstanten Netzwerken, ist, daß die Netzwerkparameter, welche die Übertragungseigenschaften bestimmen, gegenüber einem Gütefunktional optimal eingestellt werden. Ein derartiges Gütefunktional ist beispielsweise dadurch gegeben, daß der mittlere quadratische Fehler des Ausgangssignals des adaptiven Netzwerkes gegenüber einem Referenzsignal minimiert wird. Aus D.A. Pierre Optimization Theory with Applications, John Wiley and Sons, New York, 1969, ist beispielsweise ein Verfahren bekannt, bei dem die partiellen Ableitungen (Gradient) des Gütefunktionals nach den zu adaptierenden Netzwerkparametern gebildet werden. Für die meisten Gütekriterien ist dieses Verfahren jedoch zurückführbar auf die Bildung der partiellen Ableitungen des Ausgangssignals des adaptiven Netzwerkes nach den Netzwerkparametern.

Bei nichtrekursiven Strukturen wie etwa bei Finite-Impulse Response-Filtern und Transversalfiltern ist das Ausgangssignal eine Linearkombination unterschiedlich verzögerter und gewichteter Eingangssignale, wodurch die Gradientenbildung noch relativ leicht durchzuführen ist.

Bei rekursiven Strukturen hingegen ist die genannte Problematik wesentlich komplexer und wurde bislang nur für sehr spezielle Strukturen gelöst. Beispielsweise bei S. Horvath, "Adaptive rekursive Entzerrer für schnelle Datenübertragung", ETH Zürich, Dissertation ETH 5860, 1977, ist eine Lösung für eine Kaskadenschaltung von Systemen zweiter Ordnung, für Filter mit erster und zweiter kanonischer Struktur und für Lattice-Filter beschrieben. Eine Lösung für Filter mit Gray- und Markel-Struktur ist zum Beispiel aus D. Parikh, N. Ahmed, S.D. Stearns, "An Adaptive Lattice Algorithm for Recursive Filter", IEEE Trans. on Accoustic Speech and Signal Proc., Band ASSP-28, Nr. 1, Feb. 1980, bekannt. Auf einer Gradientenbildung beruhende Lösungsansätze für Lattice-Filter und die dabei auftretenden Probleme werden beispielsweise von John J. Shynk, "On Lattice-Form Algorithmus for Adaptive IIR Filtering"; ICASSP 88, 11.-14.April 1988, New York, Seiten 1554 bis 1557, und von I.L. Ayala, "On a New Adaptive Lattice Algorithm for Recursive Filters", IEEE Transactions on Aconstics, Speech and Signal Processing, Vol. ASSP-30, No.2, April 1982, Seiten 316 bis 319, aufgezeigt. Nachteile der bekannten Verfahren sind, daß diese verhältnismäßig aufwendig und nur jeweils für eine bestimmte, sehr spezielle Struktur gültig sind.

Aufgabe der Erfindung ist es daher, ein Verfahren zur Gewinnung des Gradienten der Ausgangssignale eines beliebigen gegebenen Netzwerkes zur Verarbeitung zeitdiskreter Signale bezüglich der Netzwerkparameter, sowie eine Anordnung zur Durchführung des Verfahrens anzugeben.

Diese Aufgabe wird bei einem gattungsgemäßen Verfahren durch die kennzeichnenden Merkmale des Patentanspruches 1 gelöst. Eine erfindungsgemäße Netzwerkanordnung ist im Patentanspruch 2 angegeben. Ausgestaltungen und Weiterbildungen des Erfindungsgedankens sind in Unteransprüchen gekennzeichnet.

Vorteil der Erfindung ist es, daß mit geringem Aufwand der Gradient für beliebige, rekursive und nichtrekursive Netzwerke gebildet werden kann. Darüber hinaus ist das erfindungsgemäßen Verfahren auch auf nichtlineare Netzwerke, die beispielsweise Modulatoren, Quantisierer oder Einrichtungen zur Überlaufkorrektur beinhalten, anwendbar.

Die Erfindung wird nachfolgend anhand von den in den Figuren der Zeichnung dargestellten Ausführungsbeispielen näher erläutert. Dabei sind gleiche Elemente mit gleichen Bezugszeichen versehen.

Es zeigt:

FIG 1 ein gegebenes zeitdiskretes Netzwerk nach der Aufspaltung in zwei Teilnetzwerke,

FIG 2 eine prinzipielle Ausführungsform einer erfindungsgemäßen Netzwerkanordnung,

FIG 3 eine grundsätzliche Ausführungsform einer erfindungsgemäßen Netzwerkanordnung mit einem gegebenen linearen Netzwerk,

FIG 4 eine grundsätzliche Ausführungsform einer erfindungsgemäßen Netzwerkanordnung mit einem gegebenen linearen Netzwerk mit konzentrierten Parametern,

FIG 5 eine grundsätzliche Ausführungsform einer erfindungsgemäßen Netzwerkanordnung mit einem gegebenen linearen Netzwerk mit Leistungswellen-Zweitoradaptoren

FIG 6 eine Ausführungsform einer erfindungsgemäßen Netzwerkanordnung mit einem Wellendigitalfilter mit verteilten Netzwerkparametern als gegebenem Netzwerk, und

FIG 7 eine Ausführungsform einer erfindungsgemäßen Netzwerkanordnung bei einem nichtlinearen Filter mit konzentrierten Netzwerkparmetern als gegebenem Netzwerk.

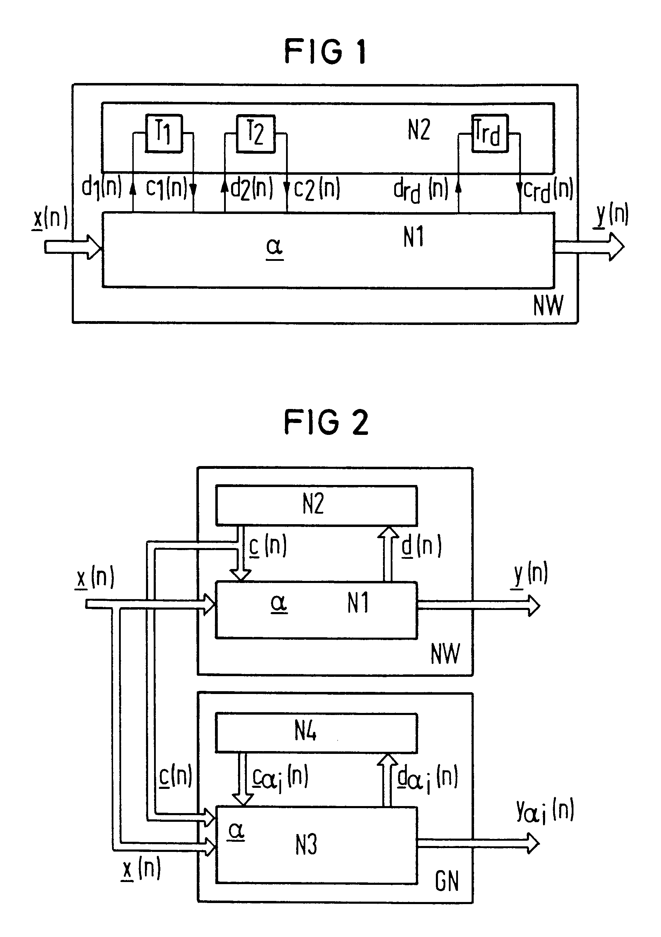

Gemäß FIG 1 der Zeichnung ist ein gegebenes Netzwerk NW mit einer Anzahl $r_x$ von zeitdiskreten Eingangssignalen

$$x_1(n), \ldots, x_{r_x}(n)$$

beaufschlagt, das seinerseits eine Anzahl $r_y$ von Ausgangssignalen

$$y_1(n), \ldots, y_{r_y}(n)$$

abgibt. Diese Signale werden in folgenden jeweils zu einem Eingangssignalvektor $\underline{x}(n)$ bzw. zu einem Ausgangssignalvektor $\underline{y}(n)$ zusammengefaßt. Alle auftretenden Signale sind dabei von der diskretisierten Zeit n abhängig.

Das Übertragungsverhalten des Netzwerkes NW ergibt sich aus den $r_\alpha$ Netzwerkparametern

$$\alpha_1, \ldots, \alpha_{r_\alpha}$$

ab, die zu einem Netzwerkparametervektor $\underline{\alpha}$ zusammengefaßt sind. Die partiellen Ableitungen des Ausgangssignalvektors $\underline{y}(n)$ nach den einzelnen Netzwerkparametern

$$\alpha_1, \ldots, \alpha_{r_\alpha}$$

$$\frac{\partial \underline{y}(n)}{\partial \alpha_1}, \ldots, \frac{\partial \underline{y}(n)}{\partial \alpha_{r_\alpha}} \tag{1}$$

können ihrerseits als $r_\alpha$ Signalvektoren der Ordnung $r_y$ beschrieben werden, die im folgenden mit

$$\underline{y}_{\alpha_1}(n) = \frac{\partial \underline{y}(n)}{\partial \alpha_1}, \ldots, \underline{y}_{\alpha_{r_\alpha}}(n) = \frac{\partial \underline{y}(n)}{\partial \alpha_{r_\alpha}} \tag{2}$$

bezeichnet werden.

Das gegebene Netzwerk NW wird erfindungsgemäß in ein ausschließlich aus verzögerungsfreien Elementen bestehendes, erstes Teilnetzwerk N1 und in ausschießlich ideale Verzögerungselemente

$$T_1 \ldots T_{r_d}$$

aufweisendes, zweites Teilnetzwerk N2 aufgespalten. Das erste Teilnetzwerk N1 gibt dabei an das zweite Teilnetzwerk N2 $r_d$ Signale

$$d_1(n), \ldots, d_{r_d}(n)$$

3

ab, die jeweils um eine Zeit

$$k_1, \ldots, k_{r_d}$$

verzögert an das erste Teilnetzwerk N1 als Signale

$$c_1(n), \ldots, c_{r_d}(n)$$

zurückgeführt werden. Die Signale

$$d_1(n), \ldots, d_{r_d}(n)$$

bzw.

$$c_1(n), \ldots, c_{r_d}(n)$$

werden im folgenden zu dem Signalvektor $\underline{d}(n)$ bzw. $\underline{c}(n)$ zusammengefaßt, wobei der Zusammenhang beider Signalvektoren $\underline{d}(n)$ und $\underline{c}(n)$ durch folgende Beziehung wiedergegeben werden kann:

$$\begin{bmatrix} c_1(n) \\ c_2(n) \\ \vdots \\ c_{r_d}(n) \end{bmatrix} = \begin{bmatrix} d_1(n - k_1) \\ d_2(n - k_2) \\ \vdots \\ d_{r_d}(n - k_{r_d}) \end{bmatrix} \qquad (3)$$

Das erste Teilnetzwerk N1 ist zudem mit dem Eingangssignalvektor $\underline{x}(n)$ beaufschlagt und führt den Ausgangssignalvektor $\underline{y}(n)$. Da das erste Teilnetzwerk N1 verzögerungsfrei ist, kann dessen Übertragungsverhalten direkt durch eine Übertragungsfunktion $\underline{h}$ in Abhängigkeit vom Eingangssignalvektor $\underline{x}(n)$, vom Netzwerkparametervektor $\underline{\alpha}$ und vom Signalvektor $\underline{c}(n)$ beschrieben werden.

$$\begin{pmatrix} \underline{y}(n) \\ \underline{c}'(n) \end{pmatrix} = \underline{h}(\underline{x}(n), \underline{c}(n), \underline{\alpha}). \qquad (4)$$

Aus den Gleichungen (3) und (4) folgt für die partiellen Ableitungen

$$c_{1\alpha_i}(n), \ldots, c_{r_d \alpha_i}(n)$$

4

des Signalvektors $\underline{c}(n)$ nach einem bestimmten Parameter $\alpha_i$:

$$\begin{bmatrix} c_{1_{\alpha_i}}(n) \\ c_{2_{\alpha_i}}(n) \\ \vdots \\ c_{r_{d_{\alpha_i}}}(n) \end{bmatrix} = \begin{bmatrix} d_{1_{\alpha_i}}(n-k_1) \\ d_{2_{\alpha_i}}(n-k_2) \\ \vdots \\ d_{r_{d_{\alpha_i}}}(n-k_{r_d}) \end{bmatrix} \qquad (5)$$

woraus sich ein Übertragungsverhalten ergibt, das formal die partiellen Ableitungen

$$\underline{y}_{\alpha_i}(n) \quad \text{bzw.} \quad \underline{d}_{\alpha_i}(n)$$

des Ausgangssignalvektors $\underline{y}(n)$ bzw. des Signalvectors $\underline{d}(n)$ nach einem bestimmten Netzwerkparameter $\alpha_i$ wie folgt beschreibt:

$$\begin{pmatrix} \underline{y}_{\alpha_i}(n) \\ \underline{d}_{\alpha_i}(n) \end{pmatrix} = \sum_{j=1}^{r_d} \underline{h}_{c_j}(\underline{x}(n), \underline{c}(n), \underline{\alpha}) c_{j_{\alpha_i}}(n) + \underline{h}_{\alpha_i}(\underline{x}(n), \underline{c}(n), \underline{\alpha}) \qquad (6)$$

Die partiellen Ableitungen

$$\underline{y}_{\alpha_i}(n) \quad \text{bzw.} \quad \underline{d}_{\alpha_i}(n)$$

sind also gleich der Summe über alle Signale, weiche Jeweils aus der Multiplikation der partiellen Ableitungen

$$c_{1\alpha_i}, \ldots, c_{r_d\alpha_i}(n)$$

mit einer von den Signalvektoren $\underline{x}(n)$, $\underline{c}(n)$ sowie dem Netzwerkparametervektor $\underline{\alpha}$ abhängigen Übertragungsfunktion $\underline{h}_{c_j}$ und über alle Signale, welche aus der Verknüpfung der Signalvektoren $\underline{x}(n)$ und $\underline{c}(n)$ sowie des Netzwerkparametervektors $\underline{\alpha}$ über eine Übertragungsfunktion

$$\underline{h}_{\alpha_i}$$

hervorgeht. Die Übertragungsfunktion(en) $\underline{h}_{c_j}$ ergeben sich aus den partiellen Ableitungen der Übertragungsfunktion $\underline{h}$ nach den Signalen

$$c_1(n), \ldots, c_{r_d}(n)$$

und die Übertragungsfunktion

$$\underline{h}_{\alpha_i}$$

ergibt sich aus der partiellen Ableitung der Übertragungsfuncktion $\underline{h}$ nach dem bestimmten Netzwerkparameter $\alpha_i$. Dabei ist die partielle Ableitung des Eingangssignalvektors $\underline{x}(n)$ nach dem bestimmten Netzwerkparameter $\alpha_i$ gleich null, da der Eingangssignalvektor $\underline{x}(n)$ nicht von dem bestimmten Netzwerkparameter $\alpha_i$ abhängt.

5

EP 0 397 912 B1

Demzufolge wird dadurch ein drittes Teilnetzwerk N3 gebildet, dessen Übertragungsfunktion $g$ sich aus Gleichung (6) ergibt. Damit folgt für die Übertragungsfunktion $g$ in Abhängigkeit vom Eingangssignalvektor $\underline{x}(n)$, vom Signalvektor $\underline{c}(n)$, vom Signalvektor $\underline{c}(n)$, vom Signalvektor

$$\underline{c}_{\alpha_i}(n)$$

der Signale

$$c_{1\alpha_i}(n), \ldots, c_{r_d\alpha_i}(n)$$

sowie vom Netzwerkparametervektor $\underline{\alpha}$:

$$\underline{g}(\underline{x}(n), \underline{c}(n), \underline{c}_{\alpha_i}(n), \underline{\alpha}) = \sum_{j=1}^{r_d} \underline{h}_{c_j}(\underline{x}(n), \underline{c}(n), \underline{\alpha})c_{j_{\alpha_i}}(n) + \underline{h}_{\alpha_i}(\underline{x}(n), \underline{c}(n), \underline{\alpha}) \quad (7)$$

Als Ausgangssignalvektor

$$\underline{y}_{\alpha_i}(n)$$

des dritten Teilnetzwerkes N3 ergeben sich somit die partiellen Ableitungen des Ausgangssignalvektors $\underline{y}(n)$ des ersten Teilnetzwerkes N1 nach dem bestimmten Netzwerkparameter $\alpha_i$. Darüber hinaus gibt das dritte Teilnetzwerk N3 den Signalvektor

$$\underline{d}_{\alpha_i}(n)$$

an ein viertes Netzwerk N4, das bezüglich seiner Übertragungsfunktion mit dem zweiten Netzwerk N2 identisch ist, ab und erhält von dem vierten Netzwerk N4 den Signalvektor

$$\underline{c}_{\alpha_i}(n)$$

und von dem zweiten Netzwerk N2 den Signalvektor $\underline{c}(n)$.

In FIG 2 der Zeichnung ist eine grundsätzliche Ausführungsform einer Netzwerkanordnung zur Durchführung des gezeigten Verfahrens dargestellt. Darin ist das gegebene Netzwerk NW gemäß FIG 1 in das erste und zweite Teilnetzwerk N1, N2 aufgespalten. Die beiden Teilnetzwerke N1 und N2 sind über Leitungen miteinander verbunden, auf denen die jeweils zu den Signalvektoren $\underline{d}(n)$ und $\underline{c}(n)$ zusammengefaßten Signale übertragen werden. Das erste Teilnetzwerk N1 ist zudem mit dem Eingangssignalvektor $\underline{x}(n)$ beaufschlagt und führt an seinem Ausgang den Ausgangssignalvektor $\underline{y}(n)$. Alle Netzwerkparameter des Netzwerkes NW sind in dem ersten Teilnetzwerk N1 zusammengefaßt.

Erfindungsgemäß ist ein Gradientennetzwerk GN vorgesehen, das ebenfalls in zwei Teilnetzwerke, nämlich in das dritte und vierte Teilnetzwerk N3 und N4, aufspaltbar ist. Das vierte Teilnetzwerk N4 entspricht dabei dem zweiten Teilnetzwerk N2 bezüglich der Übertragungseigenschaften. Die beiden Teilnetzwerke N3 und N4 sind über Leitungen miteinander verbunden, auf denen die Signalvektoren

$$\underline{d}_{\alpha_i}(n) \quad \text{und} \quad \underline{c}_{\alpha_i}(n)$$

übertragen werden. Das dritte Teilnetzwerk N3 ist zudem mit dem Eingangsssignalvektor $\underline{x}(n)$ und dem Signalvektor $\underline{c}(n)$ beaufschlagt und führt an seinem Ausgang den Ausgangssignalvektor

6

$$\underline{y}_{\alpha_i}(n).$$

Die Übertragungsfunktion $\underline{g}$ des dritten Teilnetzwerkes N3 hängt wie die Übertragungsfunktion $\underline{h}$ des ersten Teilnetzwerkes N1 von den Netzwerkparametervektor $\underline{\alpha}$ ab und ist in Gleichung (7) formal dargelegt.

Der Vorteil des vorgestellten Verfahrens bzw. der Netzwerkanordnung zur Durchführung des Verfahrens liegt also auch darin, daß lediglich die Synthese des dritten Teilnetzwerkes N3 erforderlich ist, da zweites und viertes Teilnetzwerk im Übertragungsverhalten bzw. im Aufbau im wesentlichen identisch sind. Im besonderen Maße ist dies vorteilhaft, wenn partielle Ableitungen des Ausgangssignalvektors $\underline{y}(n)$ nach weiteren Netzwerkparametern notwendig sind. Ableitungen nach weiteren Parametern ergeben sich in analoger Weise.

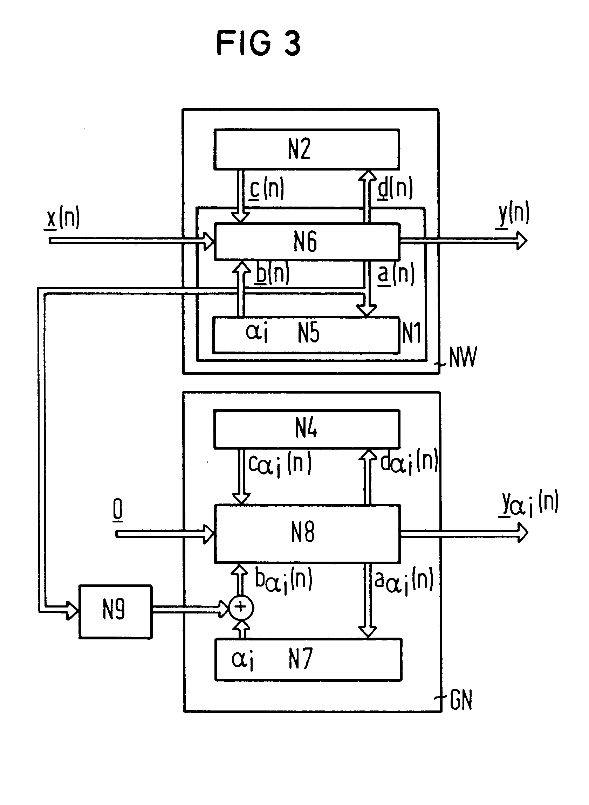

In der Ausführungsform gemäß FIG 3 weist das gegebene Netzwerk NW ein lineares Übertragungsverhalten auf. Nach der Aufspaltung in die Teilnetzwerke N1 und N2 ist eine weitere Aufspaltung des verzögerungsfreien ersten Teilnetzwerkes N1 in ein fünftes Teilnetzwerk N5, das nur von dem bestimmten Netzwerkparameter $\alpha_i$ abhängige Elemente enthält, und in eine sechstes Teilnetzwerk N6, das nur von dem bestimmten Netzwerkparameter $\alpha_i$ unäbhängige Elemente enthält, vorgesehen. Es werden dabei von dem sechsten Teilnetzwerk N6 zu einem Signalvektor $\underline{a}(n)$ zusammengefaßte Signale an das fünfte Teilnetzwerk N5 und von diesem zu einem Signalvektor $\underline{b}(n)$ zusammengefaßte Signale an das sechste Teilnetzwerk N6 abgegeben.

Das Übertragungsverhalten der Teilnetzwerke N6 und N5 läßt sich durch zwei Übertragungsmatrizen $\underline{H}_6$ und $\underline{H}_5$ $(\alpha_i)$ beschreiben. Dadurch ergibt sich für das sechste Teilnetzwerk N6:

$$\begin{pmatrix} \underline{y}(n) \\ \underline{d}(n) \\ \underline{a}(n) \end{pmatrix} = \underline{H}_4 \begin{pmatrix} \underline{x}(n) \\ \underline{c}(n) \\ \underline{b}(n) \end{pmatrix} \tag{8}$$

und für das fünfte Teilnetzwerk N5

$$\underline{b}(n) = \underline{H}_5(\alpha_i)\underline{a}(n) \tag{9}$$

Durch Ableitung der Gleichungen (8) und (9) nach dem bestimmten Netzwerkparameter $\alpha_i$ wird

$$\begin{pmatrix} \underline{y}_{\alpha_i}(n) \\ \underline{d}_{\alpha_i}(n) \\ \underline{a}_{\alpha_i}(n) \end{pmatrix} = \underline{H}_4 \begin{pmatrix} \underline{0} \\ \underline{c}_{\alpha_i}(n) \\ \underline{b}_{\alpha_i}(n) \end{pmatrix} \tag{10}$$

und

$$\underline{b}_{\alpha_i}(n) = \underline{H}_5(\alpha_i)\underline{a}_{\alpha_i}(n) + \frac{\partial \underline{H}_5(\alpha_i)}{\partial \alpha_i}\underline{a}(n) \tag{11}$$

Bei dem Gradientennetzwerk GN kann nun entsprechend das dritte Teilnetzwerk N3 in ein nur vom bestimmten Netzwerkparameter $\alpha_i$ abhängige Elemente enthaltendes siebtes Teilnetzwerk N7 und in ein davon unabhängige Elemente enthaltendes achtes Teilnetzwerk N8 aufgespalten werden. Durch Einführen eines neunten Teilnetzwerkes N9 mit der Übertragungsmatrix

$$\underline{H}_9 = \frac{\partial \underline{H}_5(\alpha_i)}{\partial \alpha_i} ,$$

7

die also gleich der Ableitung der Übertragungsmatrix $\underline{H}_5(\alpha_i)$ des fünften Teilnetzwerkes N5 nach dem bestimmten Netzwerkparameter $\alpha_i$ ist, ergibt sich ein nahezu identischer Aufbau von gegebenem Netzwerk NW und Gradientennetzwerk GN. Das Übertragungsverhalten des achten Teilnetzwerkes N8 bzw. des siebten Teilnetzwerkes N7 wird dabei durch die Übertragungsmatrix $\underline{H}_4$ bzw. $\underline{H}_5(\alpha_i)$ beschrieben.

Die Unterschiede liegen lediglich darin, daß das sechste Teilnetzwerk N6 mit dem Eingangssignalvektor $\underline{x}(n)$, hingegen das dem sechsten entsprechende achte Teilnetzwerk N8 mit einem Nullvektor 8 beaufschlagt ist und daß mit dem vom siebten Teilnetzwerk N7 dem achten Teilnetzwerk N8 zurückgeführten Signalvektor der über das neunte Teilnetzwerk N9 übertragene Signalvektor $\underline{a}(n)$ additiv verknüpft ist.

Der Vorteil besteht nun darin, daß lediglich die Synthese des neunten Teilnetzwerkes N9 nötig ist, da zweites und viertes Teilnetzwerk N2 und N4, fünftes und siebtes Teilnetzwerk N5 und N7, sowie sechstes und achtes Teilnetzwerk N6 und N8 jeweils identisch in Übertragungsverhalten bzw. Aufbau sind.

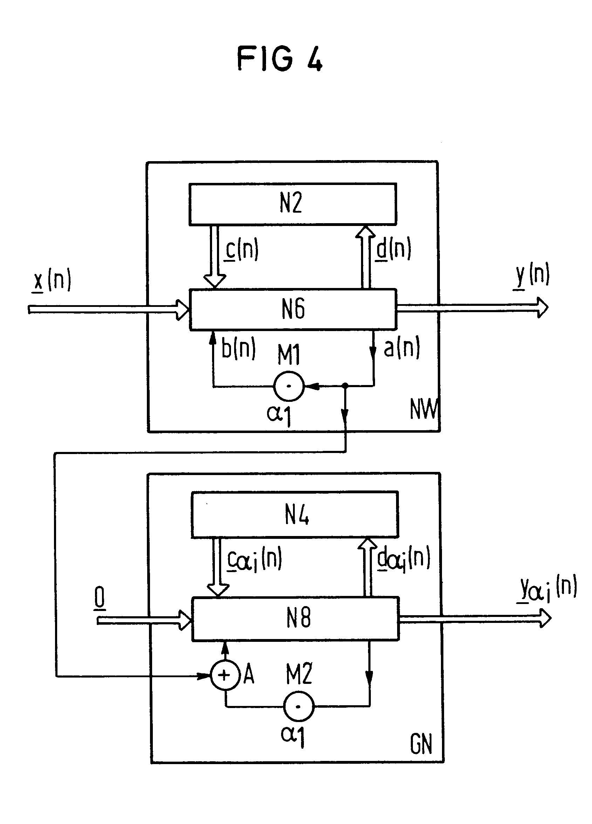

Bei dem Ausführungsbeispiel nach FIG 4 ist gegenüber FIG 3 der bestimmte Netzwerkparameter $\alpha_i$, durch einen Multipliziererkoeffizienten $\alpha_1$ gegeben. Das fünfte Teilnetzwerk N5 reduziert sich damit auf einen Mulitiplizierer M1. Dessen Übertragungsverhalten ist nun dadurch bestimmt, daß ein vom sechsten Teilnetzwerk N6 abgegebenes Signal a(n) mit dem Koeffizienten $\alpha_1$ multipliziert wird und als Signal b(n) an das sechste Teilnetzwerk N6 zurückgeführt wird. Das siebte Teilnetzwerk N7 wird ebenfalls durch einen Multiplizierer M2 gebildet, dessen Ausgangssignal mittels eines Addierers A mit dem durch das neunte Teilnetzwerk N9 übertragene Signal a(n) additiv verknüpft und an das achte Teilnetzwerk N8 zurückgeführt wird.

Das Übertragungsverhalten des neunten Teilnetzwerkes N9 ergibt sich aus dem Zusammenhang, daß das Signal b(n) gleich dem Signal a(n) multipliziert mit dem Koeffizienten $\alpha_1$ ist und daß damit die Übertragungsfunktion des fünften Teilnetzwerkes $\underline{H}_5$ gleich dem Koeffizienten $\alpha_1$ ist, insgesamt für die Übertragungsfunktion $H_9$:

$$\frac{\partial H_5(\alpha_i)}{\partial \alpha_i} = 1. \qquad\qquad (12)$$

Das neunte Teilnetzwerk N9 kann somit, wie auch in FIG 4 gezeigt, durch eine Leitung ersetzt werden.

Das bringt den Vorteil mit sich, daß das gegebene Netzwerk NW und das Gradientennetzwerk GN im wesentlichen identisch im Aufbau bzw. im Übertragungsverhalten sind und lediglich vor dem Multiplizierer M1 das Signal a(n) entnommen und zu dem Ausgangssignal des Multiplizierers M2 hinzuaddiert wird.

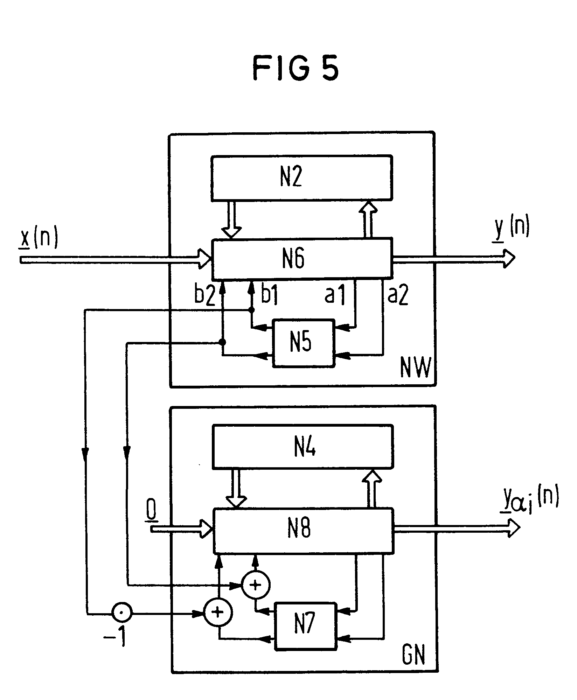

Bei dem Ausführungsbeispiel nach FIG 5 ist gegenüber FIG 3 als lineares fünftes Teilnetzwerk N5 ein Leistungswellen-Zweitoradaptor vorgesehen. Für diesen Fall ergibt sich die Übertragungsmatrix $\underline{H}_5$ des fünften Teilnetzwerkes N5 abhängig vom bestimmten Netwerkparameters

$$\underline{H}_5(\alpha_i) = \begin{pmatrix} \sin\alpha_i & \cos\alpha_i \\ \cos\alpha_i & -\sin\alpha_i \end{pmatrix} \qquad\qquad (13)$$

woraus für die Übertragungsmatrix $\underline{H}_9$ des neunten Teilnetzwerkes N9 folgt

$$\underline{H}_9 = \frac{\partial \underline{H}_5(\alpha_i)}{\partial \alpha_i} = \begin{pmatrix} \cos\alpha_i & -\sin\alpha_i \\ -\sin\alpha_i & -\cos\alpha_i \end{pmatrix} \qquad\qquad (14)$$

Damit sind wiederum das gegebene Netzwerk NW und das Gradientennetzwerk GN im wesentlichen identisch und das neunte Teilnetzwerk N9 als Leitung aufgebaut, da nun anstatt die Signale $a_1$ und $a_2$ nochmals über ein neuntes Teilnetzwerk N9 mit einer Übertragungsmatrix $\underline{H}_9$ zu führen, die Ausgangssignale $b_1$ und $b_2$ des fünften Teilnetzwerkes N5 additiv bzw. subtraktiv anstatt nur additiv mit den Ausgangssignalen des siebten Teilnetzwerkes N7 verknüpft werden, wodurch sich dann für das neunte Teilnetzwerk N9 das Übertragungsverhalten einer Leitung ergibt.

Mit den Ausgangssignalen des siebten Teilnetzwerkes N7 sind lediglich die entsprechenden Ausgangssignale $b_1$ und $b_2$ des fünften Teilnetzwerkes N5 subtraktiv bzw. additiv zu verknüpfen.

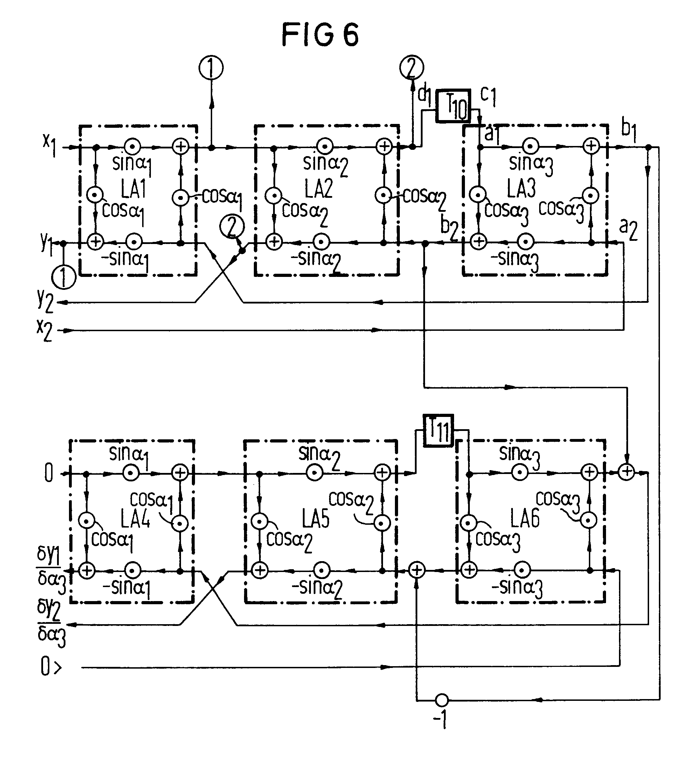

In FIG 6 der Zeichnung ist ein lineares Leistungswellen-Digitalfilter mit verteilten Netwerkparametern $\alpha_1$, $\alpha_2$ und $\alpha_3$ dargestellt. Das Filter besteht aus einem Verzögerungselement $T_{10}$ und drei Leistungswellen-Zweitoradaptoren LA1, LA2, LA3, mit den Parametern $\alpha_1$, $\alpha_2$, $\alpha_3$. Die Leistungswellen-Zweitoradaptoren umfassen jeweils 4 Multiplizierer, sowie zwei Eingänge und zwei Ausgänge. Ein Eingang, im folgenden Vorwärtseingang genannt, ist zum einen mit einem ersten Multiplizierer, der zur Multiplikation mit einer Größe $\sin\alpha_i$ vorgesehen ist, und zum anderen mit einem zweiten Multiplizierer, der zur Multiplikation mit einer Größe $\cos\alpha_i$ vorgesehen ist, verbunden. Der andere Eingang, im folgenden Rückwärtseingang genannt, ist zum einen mit einem dritten Multiplizierer, der zur Multiplikation mit einer Größe $-\sin\alpha_i$ vorgesehen ist, und zum anderen mit einem vierten Multiplizierer, der zur Mulitplikation mit der Größe $\cos\alpha_i$ vorgesehen ist, verschaltet. Den Ausgängen von erstem und viertem Multiplizierer ist ein Addierer nachgeschaltet, der auf einen Ausgang des Leistungswellen-Zweitadaptors, im folgenden mit Vorwärtsausgang bezeichnet, führt. Ebenso ist den Ausgängen von zweitem und drittem Multiplizierer ein weiterer Addierer nachgeschaltet, der auf einen weiteren Ausgang des Leistungswellen-Zweitoradaptors, im folgenden mit Rückwärtsausgang bezeichnet, führt.

Bei dem gezeigten Leistungswellen-Digtalfilter ist nun der Vorwärtsausgang des ersten Leistungswellen-Zweitoradaptors LA1 mit dem Vorwärtseingang des zweiten Leistungswellen-Zweitoradaptors LA2 verbunden, dessen Vorwärtsausgang wiederum über das Verzögerungselement $T_{10}$ mit dem Vorwärtseingang des dritten Leistungswellen-Zweitoradaptors LA3 gekoppelt ist. Zudem ist der Rückwärtsausgang des dritten auf den Rückwärtseingang des zweiten Leitungswellen-Zweitoradaptors LA2 und der Vorwärtsausgang des dritten auf den Rückwärtseingang des ersten Zweitoradaptors LA1 geführt. Am Vorwärtseingang des ersten Leistungswellen-Zweitoradaptors LA1 bzw. am Rückwärtseingang des dritten Leistungswellen-Zweitoradaptors LA3 liegen die Eingangssignale $x_1$ bzw. $x_2$ an und am Rückwärtsausgang des ersten Leistungswellen-Zweitoradaptors LA1 bzw. am Rückwärtsausgang des zweiten Leistungswellen-Zweitoradaptors LA2 liegen die Ausgangssignale $y_1$ bzw. $y_2$ an. Zur Gewinnung des Gradienten nach dem Parameter $\alpha_3$ dieses Netzwerkes ist nun ein zu diesem identisches Netzwerk mit drei Leistungswellen-Zweitoradaptoren LA4, LA5, LA6 mit den Parametern $\alpha_1$, $\alpha_2$, $\alpha_3$ sowie einem Verzögerungselement $T_{11}$ vorgesehen. Dieses Gradientennetzwerk ist statt mit den Eingangssignalen $x_1$ und $x_2$ mit jeweils einem Kurzschluß 0 beaufschlagt. Die Kopplung beider Netzwerke erfolgt zum einen durch Addition der Signale an den Rückwärtsausgängen von drittem und den Vorwärtsausgängen von sechstem Leistungswellen-Zweitoradaptor LA3, LA6 und zum anderen durch Subtraktion des Signales am Vorwärtsausgang des dritten Leistungswellen-Zweitoradaptors LA3 von dem Signal am Rückwärtsausgang des sechsten Leistungswellen-Zweitoradaptors LA6. Statt der Ausgangssignale $y_1$ und $y_2$ erscheinen damit die partiellen Ableitungen dieser Signale $\partial y_1/\partial\alpha_3$ und $\partial y_2/\partial\alpha_3$ an den entsprechenden Ausgängen.

Zur Gewinnung der Ableitungen der Signale $y_1$ und $y_2$ nach den Parametern $\alpha_1$ bzw. $\alpha_2$ ist jeweils ein weiteres identisch aufgebautes Gradiennetzwerk erforderlich. Die Kopplung dieser Gradiennetzwerke erfolgt analog zu den Leistungswellen-Zweitoradaptoren LA3 und LA6 bei dem Parameter $\alpha_3$ für die Parameter $\alpha_1$ bzw. $\alpha_2$ ausgehend von entsprechenden Stellen 1 und 2 der Leistungswellen-Zweitoradaptoren LA1 bzw. LA2 im jeweiligen Gradientenfilter an zugehöriger Stelle.

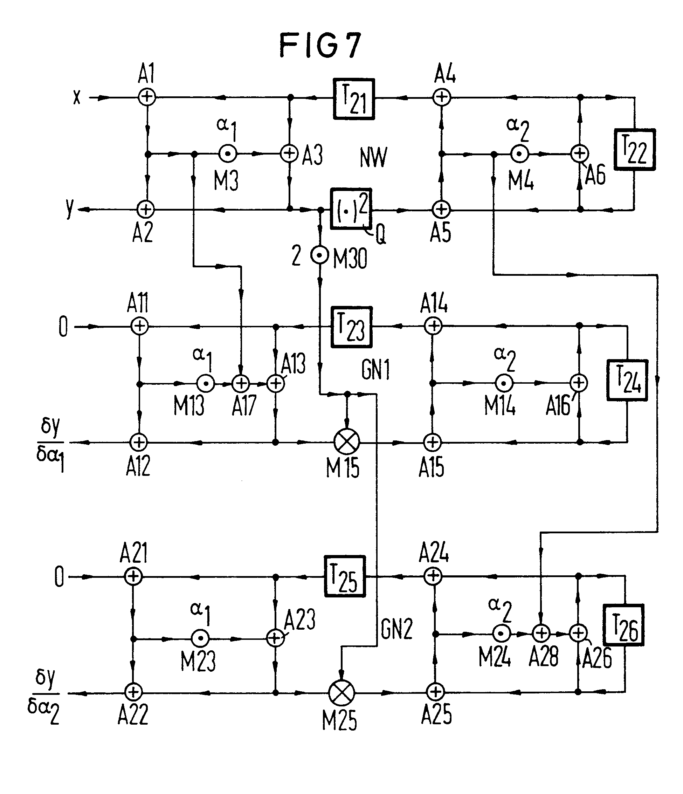

FIG 7 der Zeichnung zeigt als Ausführungsbeispiel ein gegebenes nichtlineares Filter mit den konzentrierten Parametern $\alpha_1$ und $\alpha_2$. Ein Eingangssignal x wird durch einen Addierer A1 mit dem Ausgangssignal eines Verzögerungselementes $T_{21}$ verknüpft. Der Ausgang des Addierers A1 ist zum einen auf einen Multiplizierer M3 zur Multiplikation mit dem Parameter $\alpha_1$ und zum anderen auf einen Addierer A2, an dessen Ausgang ein Ausgangssignal y anliegt und der zudem eingangsseitig mit dem Ausgang eines Addierers A3 verbunden ist, geführt. Ein Eingang des Addierers A3 ist seinerseits an den Ausgang des Multiplizierers M3 und der andere Eingang an den Ausgang des Verzögerungselementes $T_{21}$ angeschlossen. Der Eingang des Verzögerungselementes $T_{21}$ ist mit dem Ausgangssignal eines Addierers A4 beaufschlagt, der eingangsseitig durch einen Addierer A5 und einen Addierer A6 angesteuert wird. Der Addierer A6 wiederum ist eingangsseitig zum einen mit dem Ausgang eines Verzögerungselementes $T_{22}$, dessen Eingang mit dem Ausgang des Addierers A6 verschaltet ist, und zum anderen über einen Multiplizierer zur Multiplikation mit dem Parameter $\alpha_2$ mit dem Ausgang des Addierers A5 gekoppelt . Ein Eingang des Addierers A5 ist dabei mit dem Ausgang des Verzögerungselementes $T_{22}$ und der andere Eingang ist mit dem Ausgang eines nichtlinearen Elementes, nämlich eines Quadrierers Q, verbunden.

Zur Gewinnung des Gradienten $\partial y/\partial\alpha_1$ und $\partial y/\partial\alpha_2$ des Ausgangssignales y dieses Filters nach dem Parameter $\alpha_1$ bzw. $\alpha_2$ ist jeweils ein Gradientennetzwerk GN1 bzw. GN2 mit den Addieren A11 bis A16 bzw. A21 bis A26, mit den Multiplizieren M13 und M14 bzw. M23 und M24 sowie den Verzögerungselementen $T_{23}$ und $T_{24}$ bzw. $T_{25}$ und $T_{26}$ vorgesehen. Die beiden Netzwerke weisen bezüglich des Filters eine nahezu identische Struktur auf. Änderungen ergeben sich lediglich dahingehend, daß an die Stelle des Quadrierers Q bei beiden Netzwerken ein Multiplizierer M15 bzw. M25 tritt. Darüber hinaus ist bei dem

EP 0 397 912 B1

Gradientennetzwerk GN1 dem Multiplizierer M13 zur Multiplikation mit dem Parameter $\alpha_1$ ein Addierer A17 und bei dem Gradientennetzwerk GN2 dem Multiplizierer M24 zur Multiplikation mit dem Parameter $\alpha_2$ ein Addierer A28 nachgeschaltet. Der andere Eingang des Addierers A17 bzw. A28 ist mit dem Eingangssignal des Multiplizierers M3 bzw. M4 beaufschlagt. Schließlich sind die verbleibenden Eingänge der Multiplizierer M15 und M25 zusammengeführt und über einen Multiplizierer M30 zur Multiplikation mit zwei an den Ausgang des Addierers A1 angeschlossen. Die dem Eingang des Filters NW Eingänge der Gradientennetzwerke GN1 und GN2 sind mit keinem Signal (O) beaufschlagt.

Wie gezeigt wurde, ist das vorgestellte Verfahren bei beliebigen Netzwerken anwendbar, also neben linearen auch bei nichtlinearen Netzwerken. Das ist sehr vorteilhaft, da lineare Netzwerke beispielsweise durch Rundungseigenschaften oder Überlauf auch nichtlineares Verhalten zeigen können. Bevorzugt findet dieses Verfahren darüber hinaus Anwendung bei rekursiven Strukturen, wie beispielsweise bei Wellendigitalfiltern.

**Patentansprüche**

1. Verfahren zur Gewinnung des Gradienten der Ausgangssignale ($\underline{y}$) eines Netzwerkes (NW) zur Verarbeitung zeitdiskreter Signale bezüglich der Netzwerkparameter ($\underline{\alpha}$), wobei das Netzwerk (NW) aus einem verzögerungsfreien ersten Teilnetzwerk (N1), das mit Eingangssignalen ($\underline{x}$) beaufschlagt ist und welches die Ausgangssignale ($\underline{y}$) abgibt, und einem nur verzögernde Elemente aufweisenden zweiten Teilnetzwerk (N2), dem Signale ($\underline{d}$) von dem ersten Teilnetzwerk (N1) zugeführt werden und das diese Signale verzögert an das erste Teilnetzwerk (N1) zurückführt, besteht,
**dadurch gekennzeichnet,** daß jeweils dem Gradienten der Ausgangssignale ($\underline{y}$) bezüglich der Netzwerkparameter ($\underline{\alpha}$) entsprechende weitere Ausgangssignale gebildet werden, die gleich sind der Summe über alle Signale, welche aus der Verknüpfung aller Eingangssignale ($\underline{x}$), aller vom zweiten Teilnetzwerk (N2) verzögerten Signale ($\underline{c}$) und aller Netzwerkparameter ($\underline{\alpha}$) über eine erste Verknüpfungsfunktion hervorgehen, und über alle Signale, welche aus der Verknüpfung aller Eingangssignale ($\underline{x}$), aller vom zweiten Teilnetzwerk (N2) verzögerten Signale ($\underline{c}$) und aller Netzwerkparameter ($\underline{\alpha}$) über eine zweite Verknüpfungsfunktion multipliziert mit internen Signalen die entsprechend dem zweiten Teilnetzwerk (N2) verzögert sind, hervorgehen, daß die erste Verknüpfungsfunktion gleich dem Gradienten der Übertragungsfunktion des ersten Teilnetzwerkes (N1) bezüglich der Netzwerkparameter ($\underline{\alpha}$) ist, daß die zweite Verknüpfungsfunktion gleich dem Gradienten der Übertragungsfunktion des ersten Teilnetzwerkes (N1) bezüglich der vom zweiten Teilnetzwerk verzögerten Signale ($\underline{c}$) ist und daß die internen Signale gleich dem Gradienten der vom ersten Teilnetzwerk (N1) an das zweite Teilnetzwerk (N2) abgegebenen Signale ($\underline{d}$) bezüglich der Netzwerkparameter ($\underline{\alpha}$) sind.

2. Netzwerkanordnung zur Gewinnung des Gradienten der Ausgangssignale ($\underline{y}$) eines Netzwerkes (NW) zur Verarbeitung zeitdiskreter Signale bezüglich der Netzwerkparameter ($\underline{\alpha}$), wobei das Netzwerk (NW) aus einem verzögerungsfreien ersten Teilnetzwerk (N1), das mit Eingangssignalen ($\underline{x}$) beaufschlagt ist und welches die Ausgangssignale ($\underline{y}$) abgibt, und einem nur verzögernde Elemente aufweisenden zweiten Teilnetzwerk (N2), dem Signale ($\underline{d}$) von dem ersten Teilnetzwerk (N1) zugeführt werden und das diese Signale verzögert an das erste Teilnetzwerk (N1) zurückführt, besteht,
**gekennzeichnet durch** ein Gradientennetzwerk (GN) bestehend aus einem verzögerungsfreien dritten Teilnetzwerk (N3), das mit den Eingangssignalen ($\underline{x}$) und den durch das zweite Teilnetzwerk (N2) verzögerten Signalen ($\underline{c}$) des ersten Teilnetzwerkes (N1) beaufschlagt ist und das jeweils dem Gradienten der Ausgangssignale ($\underline{y}$) bezüglich der Netzwerkparameter ($\underline{\alpha}$) entsprechende weitere Ausgangssignale

$$(\underline{y}_{\alpha_i})$$

abgibt, und aus einem nur verzögernde Elemente aufweisenden vierten Teilnetzwerk (N4), dessen Übertragungsfunktion mit der des zweiten Teilnetzwerkes (N2) identisch ist, dem Signale

$$(\underline{d}_{\alpha_i})$$

des dritten Teilnetzwerkes (N3) zugeführt werden und das diese Signale verzögert an das dritte Teilnetzwerk (N3) zurückführt und durch eine Übertragungsfunktion des dritten Teilnetzwerkes (N3), die

EP 0 397 912 B1

gleich ist der Summe über den Gradienten der Übertragungsfunktion des ersten Teilnetzwerkes (N1) bezüglich der Netzwerkparameter ($\underline{\alpha}$) und über den Gradienten der Übertragungsfunktion des ersten Teilnetzwerkes (N1) bezüglich der vom zweiten Teilnetzwerk (N2) verzögerten Signale multipliziert mit den vom vierten Teilnetzwerk (N4) verzögerten Signalen.

3. Netzwerkanordnung nach Anspruch 2,
**dadurch gekennzeichnet,**
daß das Netzwerk (NW) eine lineare Übertragungsfunktion aufweist, daß das erste Teilnetzwerk (N1) aus einem fünften Teilnetzwerk (N5), das von den auf den Gradienten bezogenen Netzwerkparametern ($\alpha_i$) abhängig ist, und einem sechsten Teilnetzwerk (N6), das von diesen Netzwerkparametern ($\alpha_i$) unabhängig ist, besteht,
daß das dritte Teilnetzwerk (N3) aus einem siebten Teilnetzwerk (N7) mit einer zu dem fünften Teilnetzwerk (N5) identischen Übertragungsfunktion und einem achten Teilnetzwerk (N8) mit einer zu dem sechsten Teilnetzwerk (N6) identischen Übertragungsfunktion besteht,
daß das sechste Teilnetzwerk (N6) mit den Eingangssignalen ($\underline{x}$) und mit den von dem zweiten Teilnetzwerk (N2) verzögerten Signalen ($\underline{c}$) beaufschlagt ist und Signale ($\underline{d}$, $\underline{a}$) an das zweite und fünfte Teilnetzwerk (N2, N5) sowie Ausgangssignale ($\underline{y}$) abgibt, daß das achte Teilnetzwerk (N8) eingangsseitig mit einem Kurzschluß (O), mit von dem vierten Teilnetzwerk (N4) abgegebenen Signalen

$$( \underline{c}_{\alpha_i} )$$

und mit der Summe der Signale des siebten Teilnetzwerkes (N7) und der über ein neuntes Netzwerk (N9) geführten, vom fünften an das sechste Teilnetzwerk (N5, N6) abgegebenen Signale beaufschlagt ist und Signale an das vierte und siebte Teilnetzwerk (N4, N7) sowie weitere Ausgangssignale

$$( \underline{y}_{\alpha_i} )$$

abgibt, und daß die Übertragungsfunktion des neunten Netzwerkes (N9) gleich dem Gradienten des sechsten bzw. achten Teilnetzwerkes (N6, N8) bezüglich der Netzwerkparameter ($\alpha_i$) ist.

4. Netzwerkanordnung nach Anspruch 3,
**dadurch gekennzeichnet,** daß das fünfte bzw. siebte Teilnetzwerk (N5, N7) aus mindestens einem Multiplizierer besteht, der die von dem sechsten bzw. achten Teilnetzwerk (N6, N8) abgegebenen Signale mit jeweils einem Netzwerkparameter ($\alpha_i$) multipliziert und daß die Übertragungsfunktion des neunten Netzwerkes (N9) gleich eins ist.

5. Netzwerk nach Anspruch 3,
**dadurch gekennzeichnet,** daß das fünfte bzw. siebte Teilnetzwerk (N5, N7) ausschließlich aus Leistungswellen-Zweitoradaptoren besteht,
daß die Ausgangssignale der Leistungswellen-Zweitoradaptoren des fünften Teilnetzwerkes (N5) jeweils mit den entsprechenden Signalen des Leistungswellen-Zweitoradaptors des siebten Teilnetzwerkes (N7) additiv bzw. subtraktiv verknüpft auf das achte Teilnetzwerk (N8) geführt sind und
daß die Übertragungsfunktion des neunten Netzwerkes (N9) gleich eins ist.

**Claims**

1. Method for obtaining the gradient of output signals ($\underline{y}$) of a network (NW) for processing discrete-time signals with respect to the network parameters ($\underline{\alpha}$), the network (NW) comprising a delay-free first subnetwork (N1) which receives input signals ($\underline{x}$) and which outputs the output signals ($\underline{y}$), and a second subnetwork (N2) having only delaying elements to which signals ($\underline{d}$) from the first subnetwork (N1) are supplied and which returns said signals with a delay to the first subnetwork (N1), characterized in that further output signals corresponding to the gradient of the output signals ($\underline{y}$) with respect to the network parameters ($\underline{\alpha}$) are formed in each case which are equal to the sum of all the signals produced by gating all the input signals ($\underline{x}$), all the signals ($\underline{c}$) delayed by the second subnetwork (N2) and all the network parameters ($\underline{\alpha}$) by means of a first gating function, and of all the signals produced by gating all the input signals ($\underline{x}$), all the signals ($\underline{c}$) delayed by the second subnetwork (N2) and all the network

11

parameters ($\alpha$) by means of a second gating function multiplied by internal signals that are delayed in accordance with the second subnetwork (N2), in that the first gating function is equal to the gradient of the transfer function of the first subnetwork (N1) with respect to the network parameters ($\alpha$), in that the second gating function is equal to the gradient of the transfer function of the first subnetwork (N1) with respect to the signals ($\underline{c}$) delayed by the second subnetwork, and in that the internal signals are equal to the gradient of the signals ($\underline{d}$) output to the second subnetwork (N2) by the first subnetwork (N1) with respect to the network parameters ($\alpha$).

2. Network arrangement for obtaining the gradient of output signals ($\underline{y}$) of a network (NW) for processing discrete-time signals with respect to the network parameters ($\alpha$), the network (NW) comprising a delay-free first subnetwork (N1) which receives input signals ($\underline{x}$) and which outputs the output signals ($\underline{y}$), and a second subnetwork (N2) having only delaying elements to which signals ($\underline{d}$) from the first subnetwork (N1) are supplied and which returns said signals with a delay to the first subnetwork (N1), characterized by a gradient network (GN) comprising a delay-free third subnetwork (N3) which receives the input signals ($\underline{x}$) and the signals ($\underline{c}$) of the first subnetwork (N1) delayed by the second subnetwork (N2) and which outputs in each case further output signals ($\underline{y}\alpha_i$) corresponding to the gradient of the output signals ($\underline{y}$) with respect to the network parameters ($\alpha$), and comprising a fourth subnetwork (N4) having only delaying elements, the transfer function of which is identical to that of the second subnetwork (N2), to which signals ($\underline{d}\alpha_i$) of the third subnetwork (N3) are supplied and which returns said signals with a delay to the third subnetwork (N3), and by a transfer function of the third subnetwork (N3) which is equal to the sum of the gradient of the transfer function of the first subnetwork (N1) with respect to the network parameters ($\alpha$) and of the gradient of the transfer function of the first subnetwork (N1) with respect to the signals delayed by the second subnetwork (N2) multiplied by the signals delayed by the fourth subnetwork (N4).

3. Network arrangement according to Claim 2, characterized in that the network (NW) has a linear transfer function, in that the first subnetwork (N1) comprises a fifth subnetwork (N5) which is dependent on the network parameters ($\alpha_i$) relating to the gradient, and a sixth subnetwork (N6) which is independent of said network parameters ($\alpha i$), in that the third subnetwork (N3) comprises a seventh subnetwork (N7) having a transfer function identical to the fifth subnetwork (N5) and an eighth subnetwork (N8) having a transfer function identical to the sixth subnetwork (N6), in that the sixth subnetwork (N6) receives the input signals ($\underline{x}$) and the signals ($\underline{c}$) delayed by the second subnetwork (N2) and outputs signals ($\underline{d}$, $\underline{a}$) to the second and fifth subnetwork (N2, N5) as well as output signals ($\underline{y}$), in that the eighth subnetwork (N8) receives on the input side a short-circuit (O), signals ($\underline{c}\alpha_i$) output by the fourth subnetwork (N4) and the sum of the signals of the seventh subnetwork (N7) and the signals carried via a ninth subnetwork (N9) output from the fifth to the sixth subnetwork (N5, N6), and outputs signals to the fourth and seventh subnetwork (N4, N7) as well as further output signals ($\underline{y}\alpha_i$), and in that the transfer function of the ninth network (N9) is equal to the gradient of the sixth and eighth subnetwork (N6, N8) respectively with respect to the network parameters ($\alpha_i$).

4. Network arrangement according to Claim 3, characterized in that the fifth and seventh subnetwork (N5, N7) respectively comprises at least one multiplier which multiplies the signals output by the sixth and eighth subnetwork (N6, N8) respectively by one network parameter ($\alpha_i$) in each case, and in that the transfer function of the ninth network (N9) is equal to one.

5. Network according to Claim 3, characterized in that the fifth and seventh subnetwork (N5, N7) respectively exclusively comprises power wave two-gate adaptors, in that the output signals of the power wave two-gate adaptors of the fifth subnetwork (N5) are additively or subtractively gated respectively with the corresponding signals of the power wave two-gate adaptor of the seventh subnetwork (N7) in each case and fed to the eighth subnetwork (N8), and in that the transfer function of the ninth subnetwork (N9) is equal to one.

**Revendications**

1. Procédé pour obtenir le gradient des signaux de sortie ($\underline{y}$) d'un réseau (NW) servant à traiter des signaux discrets dans le temps, en rapport avec les paramètres ($\underline{\alpha}$) du reseau, le réseau (NW) étant constitué par un premier réseau partiel (N1), qui ne présente aucun retard, est chargé par des signaux d'entrée ($\underline{x}$) et qui délivre les signaux de sortie ($\underline{y}$), et par un second réseau partiel (N2), qui comporte uniquement des éléments produisant un retard et auxquels le premier réseau partiel (N1) envoie des signaux (d) et qui renvoie ces signaux d'une manière retardée au premier réseau partiel (N1), caractérisé par le fait que d'autres signaux de sortie, qui correspondent respectivement au gradient des signaux de sortie (y) en rapport avec les paramètres (α) du réseau sont formés, ces signaux étant égaux à la somme de tous les signaux qui sont fournis par la combinaison de tous les signaux d'entrée (x), de tous les signaux (c) retardés par le second réseau partiel (2) et de tous les paramètres (α) du réseau, par l'intermédiaire d'une première fonction combinatoire, et de tous les signaux, qui sont fournis par la combinaison de tous les signaux d'entrée (x), de tous les signaux (c) retardés par le second réseau partiel (L2) et de tous les paramètres (α) du réseau, par l'intermédiaire d'une seconde fonction combinatoire, en étant multipliés par les signaux internes qui sont retardés conformément au second réseau partiel (N2), que la première fonction combinatoire est égale au gradient de la fonction de transfert du premier réseau partiel (N1) en rapport avec les paramètres (α) du réseau, que la seconde fonction combinatoire est égale au gradient de la fonction de transmission du premier réseau partiel (N1) en rapport avec les signaux (c) retardés par le second réseau partiel, et que les signaux internes sont égaux au gradient des signaux (d), délivrés par le premier réseau partiel (N1) au second réseau partiel (N2), en rapport avec les paramètres (α) du réseau.

2. Dispositif à réseaux pour l'obtention du gradient des signaux de sortie (y) d'un réseau (NW) servant à traiter des signaux discrets dans le temps, en rapport avec les paramètres (α) du réseau, le réseau (NW) étant constitué par un premier réseau partiel (N1), qui ne présente aucun retard et est chargé par des signaux d'entrée (x) et qui délivre les signaux de sortie (y), et par un second réseau partiel (N2), qui comporte uniquement des éléments produisant un retard et auxquels le premier réseau partiel (N1) envoie des signaux (d) et qui renvoie ces signaux d'une manière retardée au premier réseau partiel (N1), caractérisé par un réseau à gradient (GN) constitué par un troisième réseau partiel (N3), qui ne produit aucun retard et qui est chargé par les signaux d'entrée (x) et par les signaux (c), retardés par le second réseau partiel (N2), du premier réseau partiel (N1) et qui délivre d'autres signaux de sortie (y$_{αi}$), qui correspondent respectivement au gradient des signaux de sortie (y) en rapport avec les paramètres (α) du réseau, et par un quatrième réseau partiel (N4), qui possède uniquement des éléments produisant un retard et dont la fonction de transfert est identique à celle du second réseau partiel (N2) et auquel sont envoyés des signaux (d$_{αi}$) du troisième réseau partiel (N3) et qui envoie ces signaux, avec un retard au troisième réseau partiel (N3), et par une fonction de transfert du troisième réseau partiel (N3), qui est égale à la somme effectuée sur le gradient de la fonction de transfert du premier réseau partiel (N1) en rapport avec les paramètres (α) du réseau et sur le gradient de la fonction de transfert du premier réseau partiel (N1) en rapport avec les signaux retardés pour le second réseau partiel (N2), est multipliée par les signaux retardés par le quatrième réseau partiel (N4).

3. Dispositif à réseaux suivant la revendication 2, caractérisé par le fait
que le réseau (NW) possède une fonction de transfert linéaire, que le premier réseau partiel (N1) est constitué par un cinquième réseau partiel (N5), qui dépend des paramètres (α$_i$) du réseau rapportés au gradient, et par un sixième réseau partiel (N6), qui est indépendant de ces paramètres (α$_i$) du réseau,
que le troisième réseau linéaire (N3) est constitué par un septième réseau partiel (N7) possédant une fonction de transfert identique à celle du cinquième réseau partiel (N5), et par un huitième réseau partiel (N8) possédant une fonction de transfert identique à celle du sixième réseau partiel (N6),
que le sixième réseau partiel (N6) est chargé par les signaux d'entrée (x) et par les signaux (c) retardés par le second réseau partiel (N2), et délivre des signaux (b, a) aux second et cinquième réseaux (N2, N5) ainsi que des signaux de sortie (y),
que le huitième réseau partiel (N8) est chargé, côté entrée, par un court-circuit (O), par des signaux (c$_{αi}$) et avec la somme des signaux du septième réseau partiel (LZ) et des signaux envoyés par un neuvième réseau (N9) et délivrés par le cinquième réseau partiel (N5) au sixième réseau partiel (N6), et envoie des signaux aux quatrième et septième réseaux partiels (N4, N7), ainsi que d'autres signaux de sortie (y$_{αi}$), et que la fonction de transfert du neuvième réseau partiel (N9) est égale au gradient du sixième ou du huitième réseau partiel (N6, N8) en rapport avec les paramètres (α$_i$).

4. dispositif à réseau suivant la revendication 3, caractérisé par le fait que le cinquième ou le sixième réseau partiel (N5, N7) est constitué par au moins un multiplicateur, qui multiplie les signaux délivrés par le sixième ou le huitième réseau partiel (N6, N8) respectivement par un paramètre (α$_i$) du réseau, et que la fonction de transfert du neuvième réseau (N9) est égale à un.

5. Réseau suivant la revendication 3, caractérisé par le fait
que le cinquième ou le septième réseau partiel (N5, N7) est constitué exclusivement par des adaptateurs d'ondes de puissance à deux portes,
que les signaux de sortie des adaptateurs d'ondes de puissance à deux portes du cinquième réseau partiel (N5) sont envoyés, en étant combinés respectivement de façon additive ou soustractive aux signaux correspondants de l'adaptateur d'ondes de puissance à deux portes du septième réseau partiel (N7), au huitième réseau partiel (N8), et
que la fonction de transfert du neuvième réseau (N9) est égale à un.

# FIG 1

# FIG 2

# FIG 3

# FIG 4

# FIG 5

# FIG 6

# FIG 7